# EUROPÄISCHE PATENTSCHRIFT

(11) **EP 1 319 253 B1**
(45) Veröffentlichungstag und Bekanntmachung des Hinweises auf die Patenterteilung: **31.10.2007**
(21) Anmeldenummer: 01976231.9
(22) Anmeldetag: 17.09.2001
(51) Int. Cl.: H01L 29/78

(54) **STEUERBARES HALBLEITERBAUELEMENT**
CONTROLLABLE SEMICONDUCTOR COMPONENT
COMPOSANT A SEMICONDUCTEUR COMMANDABLE

(30) Priorität: 22.09.2000 DE 10047168
(43) Veröffentlichungstag der Anmeldung: 18.06.2003
(73) Patentinhaber: Infineon Technologies AG, 81669 München (DE)
(72) Erfinder: KARTAL, Veli, 81371 München (DE); SCHULZE, Hans-Joachim, 85521 Ottobrunn (DE)
(74) Vertreter: Schmuckermaier, Bernhard
(86) Internationale Anmeldenummer: PCT/EP2001/010752
(87) Internationale Veröffentlichungsnummer: WO 2002/025738

(56) Entgegenhaltungen:
- EP-A- 0 020 164
- EP-A- 0 212 120
- EP-A- 0 329 047
- EP-A- 0 330 142
- DE-A- 2 855 844
- US-A- 5 414 467
- US-A- 5 852 559
- US-A- 6 005 267

## Beschreibung

Die Erfindung betrifft ein steuerbares Halbleiterbauelement, mit
einem Körper aus dotiertem Halbleitermaterial,
zwei voneinander getrennten Elektroden, deren jede das dotierte Halbleitermaterial des Körpers kontaktiert und zwischen denen eine elektrische Betriebsspannung des Bauelements anzulegen ist, und
einer Steuerelektrode, die vom Halbleitermaterial des Körpers durch elektrisch isolierendes Material isoliert ist und an die eine elektrische Steuerspannung zur Steuerung des Bauelements anzulegen ist.

Ein bekanntes Beispiel eines Bauelements der genannten Art ist ein unipolarer MOS-Transistor, bei dem bekanntermaßen der Körper aus Halbleitermaterial mindestens eines Leitungstyps besteht, bei dem eine der beiden Elektroden eine Drain-Elektrode und die andere Elektrode eine Source-Elektrode ist, bei dem die Drain-Elektrode und die Source-Elektrode jeweils Halbleitermaterial des gleichen Leitungstyps des Körpers kontaktieren, und bei dem die Steuerelektrode als Gate-Elektrode bezeichnet ist, die sich über einen dotierten MOS-Kanal und einen an diesen Kanal grenzenden und entgegengesetzt zu diesem Kanal dotierten Bereich erstreckt, die beide im Körper aus Halbleitermaterial ausgebildet sind.

Ein Beispiel eines solchen MOS Transistors ist aus der DE-A-19628656.5 (96 P 1725) bekannt. Bei diesem Transistor besteht die Besonderheit, dass neben der Drain- und Source-Elektrode und der Gate-Elektrode noch eine lateral von der Gate-Elektrode beabstandete und vom Halbleitermaterial des Körpers durch elektrisch isolierendes Material getrennte weitere Elektrode vorhanden ist, die mit der Source-Elektrode verbunden oder mit deren elektrischem Potenzial beaufschlagt ist.

Die weitere Elektrode sorgt für eine vergleichsweise homogene Feldverteilung im Randbereich der Gate-Elektrode und verhindert so, dass die elektrische Feldstärke im Halbleitermaterial einen Stoßionisation und damit Elektronenvervielfachenden auslösenden kritischen Wert von etwa 10⁵ Volt/cm erreicht.

Ein anderes bekanntes Beispiel eines Bauelements der genannten Art ist ein bipolarer IGBT (= Isolated Gate Bipolar Transistor), bei dem bekanntermaßen der Körper aus Halbleitermaterial unterschiedlichen Leitungstyps besteht, bei dem eine der beiden Elektroden eine Anode und die andere Elektrode eine Kathode ist, bei dem die Anode Halbleitermaterial eines Leitungstyps des Körpers kontaktiert, bei dem die Kathode Halbleitermaterial des zum einen Leitungstyp entgegengesetzten Leitungstyps und/oder gleichen Leitungstyps des Körpers kontaktiert und bei die Steuerelektrode ebenfalls als Gate-Elektrode bezeichnet ist.

Aus der EP 0 330 142 A2 ist ein MESFET bekannt, der eine Drain-Elektrode, eine Source-Elektrode, erste Gate-Elektroden sowie eine zweite Gate-Elektrode aufweist. Ein Gate-Abschnitt ist über einen Widerstand an eine Spannung angeschlossen. Die ersten Gate-Elektroden sind dabei gleich weit von der Source-Elektrode beabstandet.

Aufgabe der Erfindung ist es, ein Bauelement der eingangs genannten Art bereitzustellen, bei dem an die Steuerelektrode gleichzeitig voneinander verschiedene elektrische Potentiale angelegt werden können.

Diese Aufgabe wird durch die in den Ansprüchen 1 und 2 angegebenen Merkmale gelöst.

Diese Aufgabe wird dadurch gelöst, dass erfindungsgemäß die Steuerelektrode durch mindestens eine Lücke voneinander getrennte Steuerelektrodenabschnitte aufweist. D. h. die Steuerelektrode des erfindungsgemäßen Bauelements ist eine in zwei oder mehrere durch eine oder mehrere Lücken getrennte Steuerelektrodenabschnitte geteilte Steuerelektrode und nicht wie bisher eine einzige in sich zusammenhängende oder durchgehende Steuerelektrode.

Das erfindungsgemäße Bauelement hat gegenüber den bekannten Bauelementen der genannten Art den Vorteil, dass Schaltzeiten deutlich reduziert sind.

Dem erfindungsgemäßen Bauelement liegt die Erkenntnis zugrunde, dass die Schalteigenschaft eines bekannten Bauelements der eingangs genannten Art vor allem durch eine Kapazität zwischen einer der beiden Elektrode und der Steuerelektrode und eine Kapazität zwischen der anderen Elektrode und der Steuerelektrode bestimmt werden.

Beim Ein- und/oder Ausschalten eines derartigen Bauelements müssen diese Kapazitäten umgeladen werden und während dieser Phase fließt ein Verschiebungsstrom. Der Verschiebungsstrom verursacht an einem Widerstand, durch den die Steuerelektrode üblicherweise mit einem Steueranschluss des Bauelements zum Anlegen der Steuerspannung verbunden ist, einen Spannungsabfall, welcher die Spannung am Steueranschluss des Bauelements erhöht.

Dieser Widerstand ist notwendig, um die Schaltflanken einzustellen.

Die Erhöhung der Spannung am Steueranschluss des Bauelements ist vor allem im Kurzschlussfall des Bauelementes gefährlich, weil durch diese erhöhte Spannung mehr Strom fließt und dies zu einer Zerstörung des Bauelements führen kann.

Um den durch den Verschiebungsstrom verursachten Spannungsabfall über dem Widerstand zu verringern, kann der Verschiebungsstrom durch eine antiparallel zum Widerstand geschaltete Diode umgeleitet werden. Eine andere Möglichkeit besteht in einem parallel zur Kapazität zwischen einer der beiden Elektroden und der Steuerelektrode geschalteten Kondensator.

Beim erfindungsgemäßen Bauelement können vorteilhafterweise der beim Ein- und/oder Ausschalten des Bauelements durch den Widerstand fließende Verschiebungsstrom und der damit einhergehende Spannungsabfall gering gehalten oder sogar ausgeschaltet werden, so dass die damit verbundenen und erwähnten Probleme weitgehend nicht auftreten.

Ein anderes Problem beim Kurzschlussfall eines Bauelements der eingangs genannten Art ist das Auftreten von Schwingungen, welche, bedingt durch die gemeinsame Kapazität zwischen den beiden Elektroden und der Steuerelektrode, auf eine Rückkopplung zwischen den beiden Elektroden des Bauelements zurückzuführen ist.

Auch dieses Problem kann beim erfindungsgemäßen Bauelement vorteilhafterweise herabgesetzt oder verhindert werden.

Simulationen mit einem Computer-Simulator haben vorteilhafterweise gezeigt, dass bei dem erfindungsgemäßen Bauelement die Ein- und Ausschaltverluste jeweils um ca. 15% reduziert werden können. Ebenso können die Durchlassverluste reduziert werden. Eine deutliche Reduzierung der Millerphase ist vorteilhafterweise ebenso zu verzeichnen.

Bevorzugte und vorteilhafte Ausgestaltungen des erfindungsgemäßen Bauelements gehen aus den Ansprüchen 2 bis 8 hervor.

Die Erfindung wird in der nachfolgenden Beschreibung anhand der Figuren beispielhaft näher erläutert. Es zeigen:
- Figur 1: in Seitenansicht den prinzipiellen Aufbau des erfindungsgemäßen Bauelements,
- Figuren 2 bis 4: jeweils in Seitenansicht einige konkretere Ausführungsbeispiele des erfindungsgemäßen Bauelements,
- Figur 5: in Seitenansicht einen erfindungsgemäßen IGBT, der auf dem Beispiel nach Figur 2 basiert,
- Figur 6: ein symbolisches Schaltbild des IGBT nach Figur 5, das eine erste Art einer Verschaltung der Anschlüsse der Steuerelektrodenabschnitte seiner Steuerelektrode zeigt,
- Figur 7: ein symbolisches Schaltbild des IGBT nach Figur 5, das eine andere Art einer Verschaltung der Anschlüsse der Steuerelektrodenabschnitte seiner Steuerelektrode zeigt, und
- Figur 8: ein symbolisches Schaltbild eines erfindungsgemäßen MOS-Transistors, das ebenfalls eine Art einer Verschaltung der Anschlüsse der Steuerelektrodenabschnitte seiner Steuerelektrode zeigt.

Die Figuren sind schematisch und nicht maßstäblich.

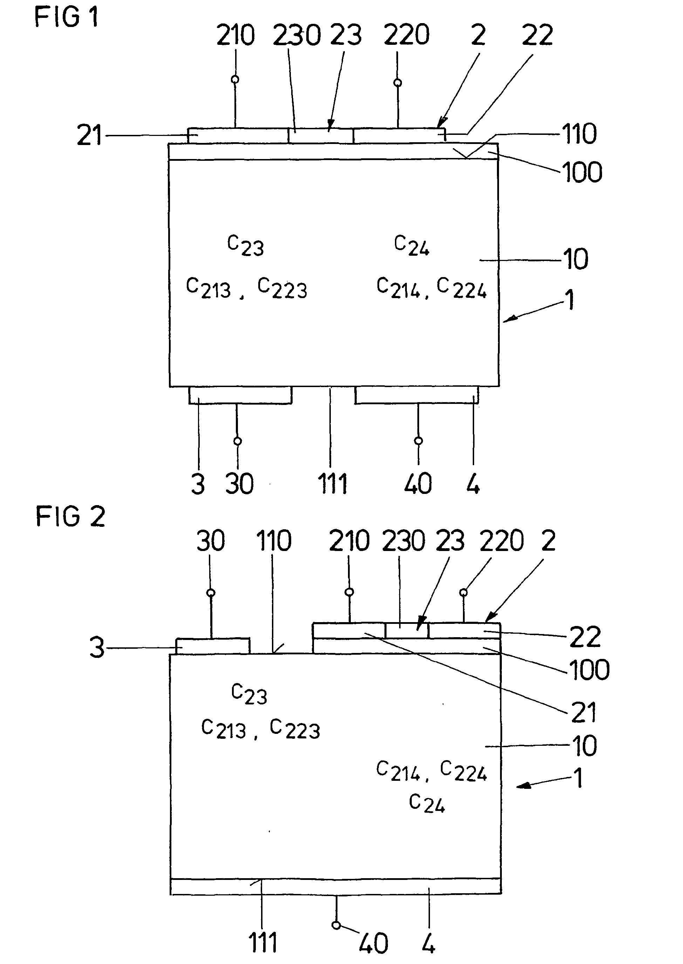

Der in der Figur 1 dargestellte prinzipielle Aufbau des generell mit 1 bezeichneten erfindungsgemäßen steuerbaren Halbleiterbauelements weist einen Körper 10 aus in der Regel unterschiedlich dotiertem Halbleitermaterial auf.

Das dotierte Halbleitermaterial des Körpers 10 kontaktieren zwei voneinander getrennten Elektroden 3 und 4, zwischen denen eine elektrische Betriebsspannung U des Bauelements 1 anzulegen ist. Die Elektroden 3 und 4 sind beispielsweise gemeinsam an einer Seitenfläche 111 des Körpers 10 angeordnet. Die Elektrode 3 ist mit einem Elektrodenanschluss 30 des Bauelements 1 und die Elektrode 4 mit einem Elektrodenanschluss 40 des Bauelements 1 verbunden. Die Elektrodenanschlüsse 30 und 40 dienen zum Anlegen der Betriebsspannung U zwischen die Elektroden 3 und 4

Auf einer von der Seitenfläche 111 abgekehrten Seitenfläche 110 des Körpers 10 ist eine Schicht 100 aus elektrisch isolierendem Material aufgebracht. Auf dieser Schicht 100 ist eine Steuerelektrode 2 aufgebracht, die somit vom Halbleitermaterial des Körpers 10 elektrisch isoliert ist und an die eine elektrische Steuerspannung U_{S} zur Steuerung des Bauelements 1 anzulegen ist.

Erfindungsgemäß weist die Steuerelektrode 2 durch mindestens eine Lücke voneinander getrennte Steuerelektrodenabschnitte auf. Bei den in den Figuren dargestellten Beispielen weist nur zwei durch eine Lücke 23 getrennte Steuerelektrodenabschnitte 21 und 22 auf. Die Steuerelektrode 2 könnte auch drei oder mehr durch zwei oder mehr Lücken getrennte Steuerelektrodenabschnitte aufweisen.

Die Lücke 23 ist mit elektrisch isolierendem Material 230 gefüllt, das die Steuerelektrodenabschnitte 21 und 22 auf der Schicht 100 elektrisch voneinander isoliert.

Der Steuerelektrodenabschnitt 21 weist einen Anschluss 210 und der Steuerelektrodenabschnitt 22 einen Anschluss 220 auf, von denen zumindest einer zum Anlegen der Steuerspannung U_{S} dient.

Die aus den beiden Steuerelektrodenabschnitten 21 und 22 bestehende Steuerelektrode 2, die Schicht 100 aus dem elektrisch isolierenden Material, der Körper 10 aus dem dotierten Halbleitermaterial und die Elektrode 3 definieren gemeinsam eine Kapazität C₂₃. Ebenso definieren die Steuerelektrode 2, die Schicht 100 aus dem elektrisch isolierenden Material, der Körper 10 aus dem dotierten Halbleitermaterial und die Elektrode 4 gemeinsam eine Kapazität C₂₄.

Es sind dies die beiden Kapazitäten C₂₃ und C₂₄, die beim Ein- und/oder Ausschalten eines herkömmlichen Bauelements umgeladen werden müssen, wodurch die erwähnten Probleme entstehen. Die erwähnten Probleme entstehen vor allem durch die Umladung der Kapazität C₂₄.

Beim erfindungsgemäßen Bauelement definieren zusätzlich:
- Der Steuerelektrodenabschnitt 21, die Schicht 100 aus dem elektrisch isolierenden Material, der Körper 10 aus dem dotierten Halbleitermaterial und die Elektrode 3 gemeinsam eine Kapazität C₂₁₃,
- der Steuerelektrodenabschnitt 21, die Schicht 100 aus dem elektrisch isolierenden Material, der Körper 10 aus dem dotierten Halbleitermaterial und die Elektrode 4 gemeinsam eine Kapazität C₂₁₄,
- der Steuerelektrodenabschnitt 22, die Schicht 100 aus dem elektrisch isolierenden Material, der Körper 10 aus dem dotierten Halbleitermaterial und die Elektrode 3 gemeinsam eine Kapazität C₂₂₃, und
- der Steuerelektrodenabschnitt 22, die Schicht 100 aus dem elektrisch isolierenden Material, der Körper 10 aus dem dotierten Halbleitermaterial und die Elektrode 4 gemeinsam eine Kapazität C₂₂₄.

Da jeder Steuerelektrodenabschnitt 21 bzw. 22 auf der Schicht 100 aus elektrisch isolierendem Material jeweils flächenmäßig kleiner als die aus beiden Steuerelektrodenabschnitten 21 und 22 bestehende Steuerelektrode 2 ist, gilt, dass jede der Kapazitäten C₂₁₃, C₂₁₄, C₂₂₃ und C₂₂₄ jeweils kleiner als die Kapazität C₂₃ und jeweils kleiner als die Kapazität C₂₄ ist.

Jede der Kapazitäten C₂₁₃, C₂₁₄, C₂₂₃ und C₂₂₄ ist auch jeweils kleiner als jede der den Kapazitäten C₂₃ und C₂₄ entsprechenden beiden Kapazitäten eines herkömmlichen Bauelements, die durch dessen einzige durchgehende Steuerelektrode mitbestimmt sind, die auf der Schicht aus elektrisch isolierendem Material dieses herkömmlichen Bauelements flächenmäßig eben so groß wie die Steuerelektrode 2 mit den beiden Steuerelektrodenabschnitte 21 und 22 des erfindungsgemäßen Bauelements ist.

Wird beim erfindungsgemäßen Bauelement 1 beispielsweise nur der Anschluss 210 des Steuerelektrodenabschnitts 21 der Steuerelektrode 2 durch einen Widerstand mit einem Steueranschluss des erfindungsgemäßen Bauelements 1 verbunden, der Anschluss 220 des anderen Steuerelektrodenabschnitts 22 dagegen nicht, ist beim Ein- und/oder Ausschalten dieses Bauelements 1 der unerwünschte Spannungsabfall über dem Widerstand vorteilhafterweise prinzipiell kleiner als bei diesem herkömmlichen Bauelement, weil an diesem Widerstand allenfalls ein durch eine Umladung der Kapazitäten C₂₁₃ und C₂₁₄ verursachter Verschiebungsstrom und nicht der durch eine Umladung der den Kapazitäten C₂₃ und C₂₄ entsprechenden größeren Kapazitäten des herkömmlichen Bauelements verursachte größere Verschiebungsstrom zur Wirkung kommt.

Das gleiche gilt im Vergleich mit diesem herkömmlichen Bauelement, wenn nur der Anschluss 220 des Steuerelektrodenabschnitts 22 der Steuerelektrode 2 durch einen Widerstand mit dem Steueranschluss des erfindungsgemäßen Bauelements 1 verbunden ist, der Anschluss 210 des Steuerelektrodenabschnitts 21 dagegen nicht.

Die Steuerelektrodenabschnitte 21 und 22 können flächenmäßig ungleich groß sich auf der Schicht 100 aus elektrisch isolierendem Material erstreckend gewählt werden.

Es gilt auch: Je kleiner die Fläche eines Steuerelektrodenabschnitts 21 oder 22 gewählt ist, desto kleiner sind die Kapazitäten C₂₁₃ und C₂₁₄ bzw. C₂₂₃ und C₂₂₄, desto kleiner ist ein durch die Umladung dieser Kapazitäten C₂₂₃ und C₂₁₄ bzw. C₂₂₃ und C₂₂₄ verursachter Verschiebungsstrom an einem Widerstand, der mit diesem Steuerelektrodenabschnitts 21 oder 22 verbunden ist, und desto kleiner ist der durch den Verschiebungsstrom verursachte Spannungsabfall über dem Widerstand.

Im folgenden sei der Einfachheit und ohne Beschränkung der Allgemeinheit angenommen, dass nur der Anschluss 210 des Steuerelektrodenabschnitts 21 über den Widerstand mit dem Steueranschluss des erfindungsgemäßen Bauelements 1 verbunden ist, der Anschluss 220 des Steuerelektrodenabschnitts 22 dagegen nicht.

Der nicht mit dem Widerstand verbundene Anschluss 220 des Steuerelektrodenabschnitts 22 wird vorzugsweise entweder direkt, d.h. ohne zwischengeschalteten Widerstand, mit dem Steueranschluss des erfindungsgemäßen Bauelements 1 verbunden oder direkt mit dem Anschluss 30 oder 40 der Elektrode 3 bzw. 4 dieses Bauelements 1 verbunden.

Jede dieser direkten Verbindungen bedeutet vorteilhafterweise jeweils, dass ein durch eine Umladung der durch den Steuerelektrodenabschnitt 22 mitbestimmten Kapazitäten C₂₂₃ und C₂₂₄ verursachter Verschiebungsstrom, unabhängig von der jeweiliger Größe dieser Kapazitäten C₂₂₃ und C₂₂₄, keinen unerwünschten Spannungsabfall über einem Widerstand erzeugen kann und eine solche Umladung zudem im Wesentlichen ohne Zeitverzögerung erfolgt.

Das oben in Bezug auf den durch den Widerstand mit dem Steueranschluss des erfindungsgemäßen Bauelements 1 verbundenen Steuerelektrodenabschnitt 21 der Steuerelektrode 2 beschriebene gilt sinngemäß genauso, wenn nur der Steuerelektrodenabschnitt 22 und nicht der Steuerelektrodenabschnitt 21 der Steuerelektrode 2 durch den Widerstand mit dem Steueranschluss des erfindungsgemäßen Bauelements 1 verbunden ist.

In den Figuren 2 bis 4 sind, nicht abschließend, einige konkretere Ausführungsbeispiele des erfindungsgemäßen Bauelements dargestellt, die beispielsweise für eine Ausbildung dieses Bauelements als IGBT und/oder MOS-Transistor geeignet sind.

Das Beispiel nach Figur 2 unterscheidet sich vom Aufbau nach Figur 1 darin, dass nur eine der beiden Elektroden 3 und 4, beispielsweise die Elektrode 4 an der Seitenfläche 111 des Körpers 10 angeordnet ist. Die andere Elektrode, im Beispiel die Elektrode 3, ist an der Seitenfläche 110 des Körpers 10 seitlich neben der diese Seitenfläche 110 nur teilweise bedeckenden Schicht 100 aus elektrisch isolierendem Material angeordnet.

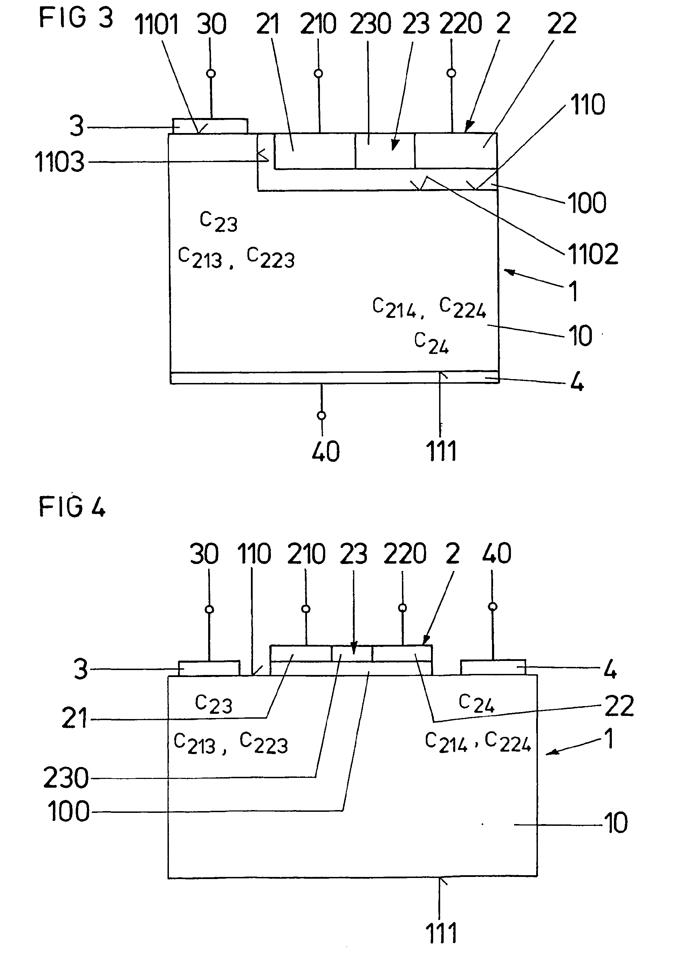

Das Beispiel nach Figur 3 unterscheidet sich vom Beispiel nach Figur 2 lediglich darin, dass die Seitenfläche 110 eine Stufe 1103 aufweist, die einen relativ höher liegenden Abschnitt 1101 der Seitenfläche 110 und einen relativ tiefer liegenden Abschnitt 1102 der Seitenfläche 110 voneinander trennt, wobei die Elektrode 3 am höher liegenden Abschnitt 1101 angeordnet ist und die Schicht 100 aus elektrisch isolierendem Material die Stufe 1103 und den tiefer liegenden Abschnitt 1102 bedeckt.

Das Beispiel nach Figur 4 unterscheidet sich vom Beispiel nach Figur 2 lediglich darin, dass auch die andere Elektrode 4 an der Seitenfläche 110 des Körpers 10 seitlich neben der diese Seitenfläche 110 nur teilweise bedeckenden Schicht 100 aus elektrisch isolierendem Material angeordnet ist, beispielsweise so, dass die Schicht 100 zwischen den Elektroden 3 und 4 angeordnet ist.

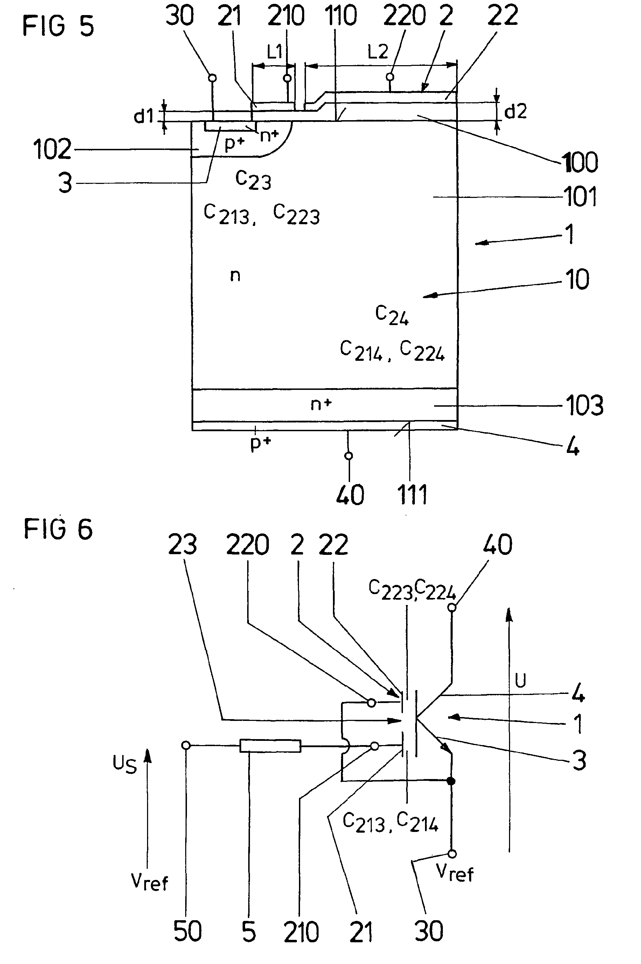

Der in der Figur 5 dargestellte beispielhafte erfindungsgemäße IGBT 1 basiert z.B. auf der Struktur nach Figur 2.

Der Körper 10 dieses IGBT 1 besteht im Wesentlichen aus n-dotiertem Halbleitermaterial, z.B. aus n-dotiertem Silizium. An der Seitenfläche 111 des Körpers 10 ist die Elektrode 4 angeordnet, die beispielsweise durch eine Schicht aus p⁺-dotiertem Silizium definiert ist und die eine Anode des IGBT 1 bildet, die mit einem Anodenanschluss 40 des IGBT 1 verbunden.

An die Anode 4 grenzt ein im Körper 10 ausgebildeter n⁺-dotierter Bereich 103. An den Bereich 103 grenzt ein n-dotierter Bereich 101, der sich bis zu der von der einen Seitenfläche 111 abgekehrten anderen Seitenfläche 110 des Körpers 10 erstreckt.

Im Bereich 101 ist eine p⁺-dotierte Wanne 102 ausgebildet, die an die andere Seitenfläche 110 des Körpers 10 grenzt und einen dotierten MOS-Kanal im Körper 10 definiert.

An der anderen Seitenfläche 110 ist im Bereich der Wanne 102 die Elektrode 3 angeordnet. Die Elektrode 3 ist beispielsweise durch eine in der Wanne 102 ausgebildete n⁺-dotierte Schicht definiert, die an die Seitenfläche 110 grenzt und die vollständig vom p⁺-dotierten Material der Wanne 102 umschlossen ist. Die Elektrode 3 bildet eine Kathode des IGBT 1 und ist mit einem Kathodenanschluss 30 des IGBT 1 verbunden.

Auf der Seitenfläche 110 des Körpers 10 ist die Schicht 100 aus elektrisch isolierendem Material, beispielsweise aus Siliziumdioxid aufgebracht. Die elektrisch isolierende Schicht 100 erstreckt sich von einer Randseite der Elektrode 3 über die an die Seitenfläche 110 des Körpers 10 grenzende Wanne 102 und über den an die Wanne 102 und die Seitenfläche 110 des Körpers 10 grenzenden n-dotierten Bereich 101 des Körpers 10.

Auf der elektrisch isolierenden Schicht 100 ist die im folgenden als Gate-Elektrode bezeichnete Steuerelektrode 2 des IGBT 1 angeordnet, die aus den beiden durch die Lücke 23 voneinander getrennten Steuer- bzw. Gate-Elektrodenabschnitten 21 und 22 besteht, wobei der Gate-Elektrodenabschnitt 21 mit einem Gate-Elektrodenanschluss 210 und der Gate-Elektrodenabschnitt 22 mit einem Gate-Elektrodenanschluss 220 verbunden ist.

Beispielsweise erstreckt sich der Gate-Elektrodenabschnitt 21 über der an die Seitenfläche 110 des Körpers 10 grenzenden Wanne 102 und der Gate-Elektrodenabschnitt 22 im Wesentlichen über dem an die Seitenfläche 110 des Körpers 10 grenzenden n-dotierten Bereich 101 außerhalb der Wanne 102.

Ein Vorteil ist, dass sich der Gate-Elektrodenabschnitt 21 im Wesentlichen nur über der an die Seitenfläche 110 des Körpers 10 grenzenden Wanne 102 und nicht über die Wanne 102 hinaus erstrecken muss. D.h., der Gate-Elektrodenabschnitt 21 erstreckt sich im Wesentlichen nur über dem an die Seitenfläche 110 des Körpers 10 grenzenden dotierten MOS-Kanal 102 des IGBT 1 und ist aus diesem Grund vorteilhafterweise flächenmäßig kleiner als eine Gate-Elektrode eines herkömmlichen IGBT, die sich über einen dotierten MOS-Kanal und zusätzlich außerhalb dieses Kanals über einen an den Kanal grenzenden und entgegengesetzt zum Kanal dotierten Bereich des Körpers aus Halbleitermaterial dieses IGBT erstreckt.

Die Fläche des Gate-Elektrodenabschnitts 21 auf der Schicht 100 aus elektrisch isolierendem Material des IGBT 1 ist allerdings nach unten begrenzt, da sich diese Fläche mit der Fläche des an die Seitenfläche 110 des Körpers 10 grenzenden dotierten MOS-Kanals 102 im Wesentlichen decken und nicht kleiner als diese Fläche des MOS-Kanal 2 sein sollte. Demgemäss ist die Fläche des Gate-Elektrodenabschnitts 21 auf der Schicht 100 aus elektrisch isolierendem Material des IGBT 1 im Wesentlichen fest vorgegeben.

Der Gate-Elektrodenabschnitt 21 des IGBT 1 nimmt beispielsweise auf der elektrisch isolierenden Schicht 100 eine kleinere Fläche ein als der sich nur über dem an die Seitenfläche 110 des Körpers 10 grenzenden n-dotierten Bereich 101 außerhalb der Wanne 102 sich erstreckende Gate-Elektrodenabschnitt 22. Dies ist daran zu erkennen, dass in der Figur 5 die Länge L1 des Gate-Elektrodenabschnitts 21 eine kürzer als die Länge L2 des Gate-Elektrodenabschnitts 22 ist.

Die Fläche des Gate-Elektrodenabschnitts 22 auf der elektrisch isolierenden Schicht 100 ist jedoch nicht fest vorgegeben, sondern kann vorteilhafterweise variabel vorgegeben werden. Insbesondere kann diese Fläche auch kleiner als die entsprechende Fläche des Gate-Elektrodenabschnitts 21 gewählt werden, wobei prinzipiell nach unten keine Grenze vorgegeben ist.

Die Gate-Elektrodenabschnitte 21 und 22 bestehen jeweils aus elektrisch leitendem Material, beispielsweise aus Polysilizium.

Die Lücke 23 zwischen den Gate-Elektrodenabschnitten 21 und 22 ist mit vorzugsweise festem elektrisch isolierenden Material, beispielsweise mit Polyimid gefüllt. Durch diese Maßnahme ist gewährleistet, dass Potentialüberschläge zwischen den beiden Gate-Elektrodenabschnitten 21 und 22 vermieden werden.

Die Dicke d1 der elektrisch isolierenden Schicht 100 unter dem Gate-Elektrodenabschnitt 21 ist kleiner als die Dicke d2 dieser Schicht 100 unter dem Gate-Elektrodenabschnitt 22. Dies hat die Wirkung, dass die von diesem Gate-Elektrodenabschnitt 22 mitbestimmten Kapazitäten C₂₂₃ und C₂₂₄ vorteilhafterweise kleiner ist als in dem Fall, dass d2 gleich d1 gewählt ist.

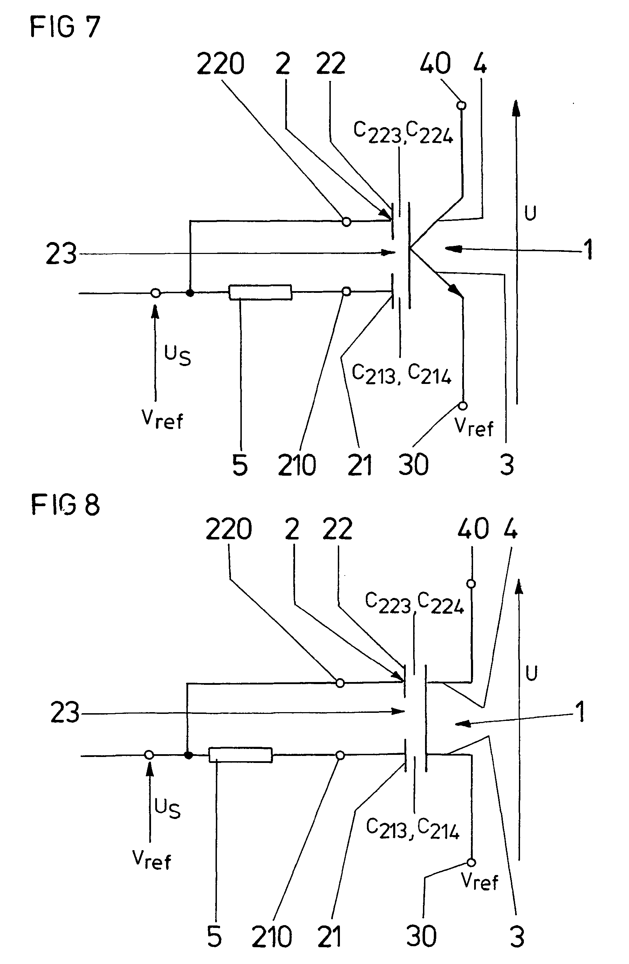

Die Schaltbilder nach den Figuren 6 und 7 basieren jeweils auf dem IGBT nach Figur 5.

Bei beiden Schaltbildern ist der Gate-Elektrodenanschluss 210 des Gate-Elektrodenabschnitts 21 über einen Widerstand 5 mit einem äußeren Steuer- oder Gateanschluss 50 des IGBT 1 verbunden.

Beim Schaltbild nach Figur 6 ist der Gate-Elektrodenanschluss 220 des Gate-Elektrodenabschnitts 22 direkt mit der Kathode 3 des IGBT 1 verbunden. Dadurch wird der durch eine Umladung der Kapazitäten C₂₂₃ und C₂₂₄ beim Ein- und/oder des IGBT 1 verursachte Verschiebungsstrom direkt zum Kathodenanschluss 30 des IGBT 1 geleitet, womit eine Rückwirkung des Anodenanschlusses 30 auf den Kathodenanschluss 40 unterbrochen ist.

Beim Schaltbild nach Figur 7 ist der Gate-Elektrodenanschluss 220 des Gate-Elektrodenabschnitts 22 direkt mit dem äußeren Gateanschluss 50 des IGBT 1 verbunden. Dadurch sind die Kapazitäten C₂₂₃ und C₂₂₄ direkt mit der Gatespannung Uₛ verbunden, die zwischen dem Gateanschluss 50 und einem Bezugspotenzial V_{ref} liegt, auf dem beispielsweise auch der Kathodenanschluss 30 liegt. Somit ist gewährleistet, dass die Kapazitäten C213, C214, C223 und C224 im statischen Betrieb auf demselben Potenzial V_{ref} + Uₛ liegen.

Bei einem entsprechend den Schaltbildern nach Figur 6 und Figur 7 verschalteten IGBT 1 spielt die Größe der Fläche des Gate-Elektrodenabschnitts 22 auf der Schicht 100 vorteilhafterweise nur eine untergeordnete, wenn nicht gar vernachlässigbare Rolle.

Das für den IGBT 1 geltende kann analog auch auf ein erfindungsgemäßes Bauelement 1 in Form eines MOS-Transistors angewendet werden.

Das Schaltbild nach Figur 8 zeigt als Beispiel symbolisch einen erfindungsgemäßen MOS-Transistor 1, der entsprechend dem IGBT 1 nach Figur 7 verschaltet ist.

Demgemäss ist bei diesem MOS-Transistor 1 nach Figur 8 der Gate-Elektrodenanschluss 210 des Gate-Elektrodenabschnitts 21 der Gate-Elektrode 2 über einen Widerstand 5 mit einem äußeren Steuer- oder Gateanschluss 50 des MOS-Transistors 1 verbunden. Der Gate-Elektrodenanschluss 220 des anderen Gate-Elektrodenabschnitts 22 der Gate-Elektrode 2 ist direkt mit dem äußeren Gateanschluss 50 des verbunden. Dadurch sind die Kapazitäten C₂₂₃ und C₂₂₄ direkt mit der Gatespannung Uₛ verbunden, die zwischen dem Gateanschluss 50 und einem Bezugspotenzial V_{ref} liegt, auf dem beispielsweise auch der Elektrodenanschluss 30 der Elektrode 3 des Transistors 1 liegt, die die Source-Elektrode des MOS-Transistors 1 bildet. Somit ist gewährleistet, dass die Kapazitäten C213, C214, C223 und C224 im statischen Betrieb auf demselben Potenzial V_{ref} + Uₛ liegen. Die mit dem Elektrodenanschluss 40 verbundene Elektrode 4 des MOS-Transistors 1 bildet die Drain-Elektrode des MOS-Transistors 1.

Der MOS-Transistor 1 nach Figur 8 könnte alternativ auch entsprechend dem IGBT 1 nach Figur 6 mit entsprechender Wirkung verschaltet sein.

Das über die Fläche des Gate-Elektrodenabschnitts 21 auf der Schicht 100 in Bezug auf den MOS-Kanal und die Fläche des Gate-Elektrodenabschnitts 22 des IGBT 1 nach den Figuren 5 bis 7 Gesagte gilt für den MOS-Transistors 1 nach Figur 8 in gleicher Weise.

## Patentansprüche

1. Steuerbares Halbleiterbauelement (1), mit
einem Körper (10) aus dotiertem Halbleitermaterial,
zwei voneinander getrennten Elektroden (3, 4), deren jede das dotierte Halbleitermaterial des Körpers (10) kontaktiert und zwischen denen eine elektrische Betriebsspannung (U) des Bauelements (1) anzulegen ist, wobei eine der beiden Elektroden (3, 4) eine Source-Elektrode (3) des Bauelements (1) und die andere Elektrode eine Drain-Elektrode (4) des Bauelements (1) ist, und
einer Steuerelektrode (2), die vom Halbleitermaterial des Körpers (10) durch elektrisch isolierendes Material (100) isoliert ist und an die eine elektrische Steuerspannung (Uₛ) zur Steuerung des Bauelements (1) anzulegen ist, wobei die Steuerelektrode durch mindestens eine Lücke (23) von einander getrennte Steuerelektrodenabschnitte (21, 22) aufweist und wobei ein der Source-Elektrode (3) nächst gelegener Steuerelektrodenabschnitt (21) durch einen elektrischen Widerstand (5) mit einem Steueranschluss (50) des Bauelements (1) zum Anlegen der Steuerspannung verbunden ist,
**dadurch gekennzeichnet, dass**
ein Steuerelektrodenabschnitt (22), der von dem durch einen elektrischen Widerstand (5) mit einem Steueranschluss (50) des Bauelements (1) verbundenen Steuerelektrodenabschnitt (21) verschieden ist, mit dem Steueranschluss (50) des Bauelements (1) zum Anlegen der Steuerspannung direkt verbunden ist.

2. Steuerbares Halbleiterbauelement (1), mit
einem Körper (10) aus dotiertem Halbleitermaterial,
zwei voneinander getrennten Elektroden (3, 4), deren jede das dotierte Halbleitermaterial des Körpers (10) kontaktiert und zwischen denen eine elektrische Betriebsspannung (U) des Bauelements (1) anzulegen ist, wobei eine der beiden Elektroden (3, 4) eine Source-Elektrode (3) des Bauelements (1) und die andere Elektrode eine Drain-Elektrode (4) des Bauelements (1) ist, und
einer Steuerelektrode (2), die vom Halbleitermaterial des Körpers (10) durch elektrisch isolierendes Material (100) isoliert ist und an die eine elektrische Steuerspannung (Uₛ) zur Steuerung des Bauelements (1) anzulegen ist, wobei die Steuerelektrode durch mindestens eine Lücke (23) von einander getrennte Steuerelektrodenabschnitte (21, 22) aufweist und wobei ein der Source-Elektrode (3) nächst gelegener Steuerelektrodenabschnitt (21) durch einen elektrischen Widerstand (5) mit einem Steueranschluss (50) des Bauelements (1) zum Anlegen der Steuerspannung verbunden ist,
**dadurch gekennzeichnet, dass**
ein Steuerelektrodenabschnitt (22), der von dem durch einen elektrischen Widerstand (5) mit einem Steueranschluss (50) des Bauelements (1) verbundenen Steuerelektrodenabschnitt (21) verschieden ist, mit einer (4) der beiden Elektroden (3, 4) verbunden ist.

3. Bauelement (1) nach einem der Ansprüche 1 bis 2, wobei
der Körper (10) aus Halbleitermaterial mindestens eines Leitungstyps (n, p) besteht, und wobei
jede der beiden Elektroden (3, 4) Halbleitermaterial des gleichen Leitungstyps (n, p) des Körpers (10) kontaktiert.

4. Bauelement (1) nach einem der vorhergehenden Ansprüche, wobei
der Körper (10) aus Halbleitermaterial unterschiedlichen Leitungstyps (n, p) besteht, und wobei
eine (3) der beiden Elektroden (3, 4) Halbleitermaterial eines Leitungstyps (n; p) des Körpers kontaktiert, und die andere Elektrode (4) Halbleitermaterial des zum einen Leitungstyp (n, p) entgegengesetzten Leitungstyps (p, n) des Körpers (10) kontaktiert.

5. Bauelement (1) nach Anspruch 4, wobei
eine (3, 4) der beiden Elektroden (3, 4) eine Kathode des Bauelements (1) ist, und
die andere Elektrode (4, 3) eine Anode des Bauelements (1) ist.

## Claims

1. Controllable semiconductor component (1), comprising
a body (10) composed of doped semiconductor material,
two electrodes (3, 4) separated from one another, each of which makes contact with the doped semiconductor material of the body (10) and between which an electrical operating voltage (U) of the component (1) is to be applied, one of the two electrodes (3, 4) being a source electrode (3) of the component (1) and the other electrode being a drain electrode (4) of the component (1), and
a control electrode (2), which is insulated from the semiconductor material of the body (10) by electrically insulating material (100) and to which is to be applied an electrical control voltage (Uₛ) for controlling the component (1), the control electrode having control electrode sections (21, 22) separated from one another by at least one gap (23), and a control electrode section (21) closest to the source electrode (3) being connected by an electrical resistor (5) to a control terminal (50) of the component (1) for application of the control voltage,
**characterized in that**
a control electrode section (22) that is different from the control electrode section (21) connected by an electrical resistor (5) to a control terminal (50) of the component (1) is directly connected to the control terminal (50) of the component (1) for application of the control voltage.

2. Controllable semiconductor component (1), comprising
a body (10) composed of doped semiconductor material,
two electrodes (3, 4) separated from one another, each of which makes contact with the doped semiconductor material of the body (10) and between which an electrical operating voltage (U) of the component (1) is to be applied, one of the two electrodes (3, 4) being a source electrode (3) of the component (1) and the other electrode being a drain electrode (4) of the component (1), and
a control electrode (2), which is insulated from the semiconductor material of the body (10) by electrically insulating material (100) and to which is to be applied an electrical control voltage (Uₛ) for controlling the component (1), the control electrode having control electrode sections (21, 22) separated from one another by at least one gap (23), and a control electrode section (21) closest to the source electrode (3) being connected by an electrical resistor (5) to a control terminal (50) of the component (1) for application of the control voltage,
**characterized in that**
a control electrode section (22) that is different from the control electrode section (21) connected by an electrical resistor (5) to a control terminal (50) of the component (1) is connected to one (4) of the two electrodes (3, 4).

3. Component (1) according to one of Claims 1 to 2,
the body (10) comprising semiconductor material of at least one conduction type (n, p), and
each of the two electrodes (3, 4) making contact with semiconductor material of the same conduction type (n, p) of the body (10).

4. Component (1) according to one of the preceding claims,
the body (10) comprising semiconductor material of different conduction types (n, p), and
one (3) of the two electrodes (3, 4) making contact with semiconductor material of one conduction type (n; p) of the body, and the other electrode (4) making contact with semiconductor material of the opposite conduction type (p, n) to said one conduction type (n, p) of the body (10).

5. Component (1) according to Claim 4,
one (3, 4) of the two electrodes (3, 4) being a cathode of the component (1), and
the other electrode (4, 3) being an anode of the component (1).

## Revendications

1. Composant semi-conducteur (1) pouvant être commandé, comprenant
un corps (10) en matériau semi-conducteur dopé,
deux électrodes (3, 4) séparées l'une de l'autre dont chacune est en contact avec le matériau semi-conducteur dopé du corps (10) et entre lesquelles on applique une tension électrique de service (U) de l'élément (1), l'une des deux électrodes (3, 4) étant une électrode source (3) de l'élément (1) alors que l'autre électrode est une électrode drain (4) de l'élément (1), et
une électrode de modulation (2) isolée du matériau semi-conducteur du corps (10) par un matériau (100) électriquement isolant et sur laquelle on applique une tension de gâchette électrique (Uₛ) servant à commander l'élément (1), sachant que l'électrode de modulation présente des segments d'électrode de modulation (21, 22) séparés les uns des autres par au moins un interstice (23) et qu'un segment d'électrode de modulation (21) situé au plus près de l'électrode source (3) est relié par une résistance électrique (5) à une borne de gâchette (50) de l'élément (1) pour appliquer la tension de gâchette,
**caractérisé en ce qu'**
un segment d'électrode de modulation (22), différent du segment d'électrode de modulation (21) relié par une résistance électrique (5) à une borne de gâchette (50) de l'élément (1), est relié directement à la borne de gâchette (50) de l'élément (1) pour appliquer la tension de gâchette.

2. Elément semi-conducteur (1) pouvant être commandé, comprenant
un corps (10) en matériau semi-conducteur dopé,
deux électrodes (3, 4) séparées l'une de l'autre dont chacune est en contact avec le matériau semi-conducteur dopé du corps (10) et entre lesquelles on applique une tension électrique de service (U) de l'élément (1), l'une des deux électrodes (3, 4) étant une électrode source (3) de l'élément (1) alors que l'autre électrode est une électrode drain (4) de l'élément (1), et
une électrode de modulation (2) isolée du matériau semi-conducteur du corps (10) par un matériau (100) électriquement isolant et sur laquelle on applique une tension de gâchette électrique (Uₛ) servant à commander l'élément (1), sachant que l'électrode de modulation présente des segments d'électrode de modulation (21, 22) séparés les uns des autres par au moins un interstice (23), et qu'un segment d'électrode de modulation (21) situé au plus près de l'électrode source (3) est relié par une résistance électrique (5) à une borne de gâchette (50) de l'élément (1) pour appliquer la tension de gâchette,
**caractérisé en ce qu'**
un segment d'électrode de modulation (22), différent du segment d'électrode de modulation (21) relié par une résistance électrique (5) à une borne de gâchette (50) de l'élément (1), est relié à l'une (4) des deux électrodes (3, 4).

3. Composant (1) selon l'une des revendications 1 à 2,
dans lequel le corps (10) est fabriqué à partir d'un matériau semi-conducteur d'au moins un type de conduction (n, p), et chacune des deux électrodes (3, 4) est en contact avec un matériau semi-conducteur du même type de conduction (n, p) du corps (10).

4. Composant (1) selon l'une quelconque des revendications précédentes,
ans lequel le corps (10) est fabriqué à partir d'un matériau semi-conducteur d'un type de conduction (n, p) différent, et l'une (3) des deux électrodes (3, 4) est en contact avec un matériau semi-conducteur d'un type de conduction (n ; p) du corps, l'autre électrode (4) étant en contact avec un matériau semi-conducteur de type de conduction (p, n) du corps (10) opposé au type de conduction (n, p).

5. Composant (1) selon la revendication 4, dans lequel l'une (3, 4) des deux électrodes (3, 4) est une cathode de l'élément (1), et l'autre électrode (4, 3) est une anode de l'élément (1).
